# EUROPEAN PATENT APPLICATION

(11) **EP 2 747 347 A1**
(43) Date of publication of application: **25.06.2014**
(21) Application number: 13196197.1
(22) Date of filing: 09.12.2013
(51) Int. Cl.: H04L 12/26, H04B 17/00, H04W 24/06

(54) **Radio frequency communication simulation**

(30) Priority: 20.12.2012 GB 201223050
(71) Applicant: Nordic Semiconductor ASA, 7004 Trondheim (NO)
(72) Inventor: Sæther, Ole, NO-7050 Trondheim (NO)
(74) Representative: Samuels, Adrian James

(57) **Abstract**

A computer software tool comprises a simulated radio frequency transmitter device (6), a simulated radio frequency receiver device (6') and a shared memory resource (10). The shared memory resource (10) is arranged to receive messages from the simulated transmitter (8) and to pass said messages to the simulated receiver (8') wherein said messages are in a format understandable by software running on both the simulated radio frequency transmitter device (6) and the simulated radio frequency receiver device (6').

## Description

This invention relates to apparatus and methods for simulating radio frequency communication between electronic devices, particularly although not exclusively in order to allow development and testing of devices.

In the development and testing of electronic devices it is often necessary to simulate RF communication between two RF transceivers, for example when exploring different implementations of transmission and reception modules. This is possible with traditional low-level hardware simulation of the radio components but this is not ideal. For one thing such hardware simulators are time consuming as they tend to be processor-intensive. They are also difficult to use as the output tends not to be in an easily understandable form.

Many commercial software development tools have integrated development environments (IDE) with high level simulators. An IDE is a software application which provides the facilities required for software development. The Keil/ARM uVision IDE is an example. This gives the ability to write our simulated hardware modules and communicate with them using the manufacturer's proprietary interface Advanced Generic Simulator Interface (AGSI). Keil uVision has the ability to run several instances side by side but there are no methods for communicating between these instances.

When viewed from a first aspect the present invention provides a computer software tool comprising a simulated radio frequency transmitter device, a separately simulated radio frequency receiver device and a shared memory resource arranged to receive messages from said simulated transmitter and to pass said messages to said simulated receiver wherein said messages are in a format understandable by software running on both said simulated radio frequency transmitter device and said simulated radio frequency receiver device.

When viewed from a second aspect the present invention provides a computer software tool comprising a simulated radio frequency transmitter device, a simulated radio frequency receiver device and a shared memory resource arranged to receive messages from said simulated transmitter and to pass said messages to said simulated receiver wherein said messages are in a format understandable by software running on both said simulated radio frequency transmitter device and said simulated radio frequency receiver device.

The invention extends to a method of simulating the operation of a radio frequency transmitter device and a separately simulated radio frequency receiver device comprising said radio frequency transmitter device generating a message, storing said message in a shared memory resource, and passing said message to said simulated radio frequency receiver device wherein said message is in a format understandable by software running on both said simulated radio frequency transmitter device and said simulated radio frequency receiver device.

The invention further extends to a method of simulating the operation of a radio frequency transmitter device and a simulated radio frequency receiver device comprising said radio frequency transmitter device generating a message, storing said message in a shared memory resource, and passing said message to said simulated radio frequency receiver device wherein said message is in a format understandable by software running on both said simulated radio frequency transmitter device and said simulated radio frequency receiver device.

Thus it will be seen by those skilled in the art that two simulated transceivers can communicate with one another by the passing of messages which they would generate and receive in use thereby allowing their operation to be fully modelled and tested but without the need for low-level hardware simulation of the physical radio module and the attendant disadvantages outlined above. Multiple separate instances of the same simulator can be generated in separate IDEs, which can communicate with one another through a common memory resource. This communication outside the IDE allows the software running on the simulated devices to behave exactly as if it is running on the real hardware sending/receiving real RF messages. The simulated devices can therefore 'believe' that they are carrying out real communication with one another.

The simulated transmitter device may also act as a receiver and the simulated receiver device may also act as a transmitter. In other words first and second transceivers may be simulated.

In a set of embodiments the simulated radio frequency transmitter device is arranged to store a data packet that would have been transmitted as a radio signal in the shared memory resource. The simulated radio frequency receiver device may then be arranged to retrieve the data packet stored in the shared memory resource.

In a set of embodiments, the simulated transmitter device is provided by a first integrated development environment, the simulated receiver device is provided by a second integrated development environment and the shared memory resource is outside the integrated development environments. This allows the two simulations to run independently, allowing for parameters of one of the simulations to be changed without the other simulation being altered or interrupted.

The inventor has recognised that the software which is being developed to run on the devices being simulated needs only to deal with specific events associated with the communication protocol such as 'packet sent' or 'packet received'. In accordance with the invention only these events need to be simulated rather than all of the numerous, typically thousands, of low level hardware events that are associated.

In a set of embodiments the shared memory resource is arranged to notify the simulated radio frequency receiver device that a packet has been stored there. For example it may be arranged to call a receive function of the simulated radio frequency receiver device. This simulates the receipt of a data packet. The simulated radio frequency receiver device may be arranged to check an RF channel and/or address of the packet. The simulated radio frequency receiver device may be arranged to trigger an interrupt if said RF channel and/or said address of the packet matches a predetermined value for the simulated radio frequency receiver device. Additionally or alternatively the shared memory resource may be arranged to notify the simulated radio frequency receiver device that a packet has been stored there. This simulates the sending of a data packet.

In a set of embodiments the shared memory resource is arranged to insert bit errors into the packets stored therein or to delete packets. This allows developers to develop and test functions and algorithms to deal with realistic environments where packets are occasionally corrupted or lost.

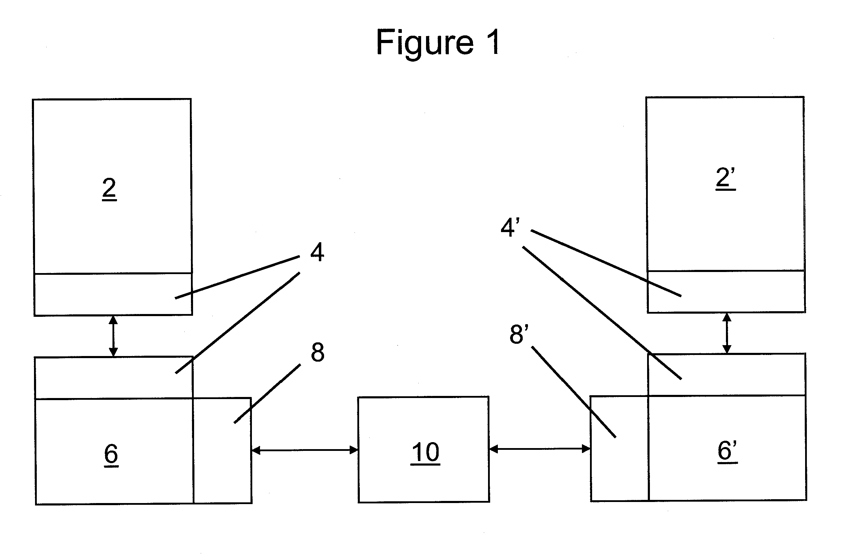

An embodiment of the invention will now be described by way of example only with reference to the accompanying drawings in which Figure 1 is a schematic representation of a system embodying the invention.

The module represented by box 2 in the Figure is a Keil/ARM uVision integrated development environment which is a commercially available software development tool. The tool includes a proprietary interface known as the Advanced Generic Simulator Interface (AGSI) 4. Using this tool a simulation of the Applicant's nRF9E5 RF Transceiver chip 6 was produced, in a manner known *per se* to those skilled in the art, controlled by the AGSI 4. In addition to an ordinary simulation of the digital operation of the chip, an additional radio module was produced to provide an interface 8 to control the transmission and reception of messages that would, in reality, pass over the air as radio waves.

A second instance 2' of the simulator was then used to produce a simulation 6' of another nRF9E5 chip with a corresponding AGSI control module 4' and a corresponding radio interface module 8'. The two radio interface modules 8, 8' are each able to communicate data to/from a shared memory resource 10.

In operation a software application written to run on the chip may be run on the two instances of the simulated chip 6, 6'. This could be the same software on each - for example where the software is for operating the chips in a balanced two-way communication application. Alternatively the software may be different on each - e.g. when implementing a master/slave arrangement.

When the software 6 would normally control the analogue part of the chip to cause a data packet to be transmitted, the radio module 8 communicates the data packet that would have been transmitted to the shared memory resource 10. The packet can then be transferred to the other simulated device 6'.

It will be understood that the radio interface modules 8, 8' are merely generating and dealing with the high-level events associated with sending and receiving packets. Typically the firmware for the devices is event-driven, meaning that most time is spent waiting for a "packet-sent event" or a "packet-received event". On a low level there are thousands of events that eventually lead to these two events but in the end it is only these events that influence the execution of the software. In a low-level hardware simulator all events in the chip will be simulated. In the receiver for example this would starts with a signal at the antenna that must be demodulated, then the cyclic redundancy check (CRC) bit must be checked and eventually after a large number of other operations a packet received event is generated if the address and CRC was correct.

In accordance with the present invention however, packet-sent and packet-received events can be generated in the same order and at the same times in the software simulator as they would occur when using the real hardware. This greatly simplifies the firmware development process. In particular the effect of trying out changes or particular test conditions can be assessed much more quickly - a software engineer can change something and get instant feedback almost with the click of a button. On a low-level hardware simulator the turn-around time could be several hours. Moreover software engineers generally don't have access to low-level hardware simulators.

Taking a specific example of operation, the first simulated chip 6 is running a temperature sensor software application and acts as a slave. The other simulated chip 6' is running a temperature monitor application and is operating as a master. The sensor application may be programmed to issue a temperature update every ten seconds. This is simulated in the device 6 which monitors timing and can determine an artificial temperature value to communicate. When a timing event is triggered the device software 6 calls a Transmit function which prompts the radio interface module 8 to place the data packet containing the deemed temperature value into the shared memory resource module 10. The shared memory then calls the Receive function of the other simulated device 6' which then checks the RF channel and address of the packet and if it matches, an RF interrupt is triggered (just as would be the case if a real receiver chip received a data packet). The second simulated chip 6' may then trigger an ack message via its radio module 8' which is stored in the shared memory resource 10 and passed to the first simulated chip 6 in a similar manner.

It will be appreciated that each simulated device may operate as a transmitter and a receiver.

The skilled person will appreciate from the above example that in accordance with at least embodiments of the invention a novel way of simulating RF communication is provided. This allows a software engineer to use an environment that he/she is familiar with to simulate a complete radio protocol without altering the software; the receiver and transmitter software can run unmodified on this model. This avoids the need for slow and cumbersome low-level hardware simulation.

## Claims

1. A computer software tool comprising a simulated radio frequency transmitter device, a separately simulated radio frequency receiver device and a shared memory resource arranged to receive messages from said simulated radio frequency transmitter device and to pass said messages to said simulated radio frequency receiver device wherein said messages are in a format understandable by software running on both said simulated radio frequency transmitter device and said simulated radio frequency receiver device.

2. A software tool as claimed in claim 1 wherein the simulated transmitter device also acts as a receiver and the simulated radio frequency receiver device also acts as a transmitter.

3. A software tool as claimed in claim 1 or 2 wherein the simulated radio frequency transmitter device is arranged to store a data packet in the shared memory resource, and wherein preferably the simulated radio frequency receiver device is arranged to retrieve the data packet stored in the shared memory resource.

4. A software tool as claimed in any preceding claim, wherein: the simulated radio frequency transmitter device is provided by a first integrated development environment; the simulated radio frequency receiver device is provided by a second integrated development environment; and the shared memory resource is outside the integrated development environments.

5. A software tool as claimed in any preceding claim wherein the shared memory resource is arranged to notify the simulated radio frequency receiver device that a packet has been stored there, and wherein preferably the simulated radio frequency receiver device is arranged to check an RF channel and/or address of the packet.

6. A software tool as claimed in claim 5 wherein the simulated radio frequency receiver device is arranged to trigger an interrupt if said RF channel and/or said address of the packet matches a predetermined value for the simulated radio frequency receiver device.

7. A software tool as claimed in any preceding claim wherein the shared memory resource is arranged to notify the simulated radio frequency receiver device that a packet has been stored there.

8. A software tool as claimed in any preceding claim wherein the shared memory resource is arranged to insert bit errors into the packets stored therein or to delete packets.

9. A method of simulating the operation of a radio frequency transmitter device and a simulated radio frequency receiver device comprising said radio frequency transmitter device generating a message, storing said message in a shared memory resource, and passing said message to said simulated radio frequency receiver device wherein said message is in a format understandable by software running on both said simulated radio frequency transmitter device and said simulated radio frequency receiver device.

10. A method as claimed in claim 9 wherein the simulated transmitter device also acts as a receiver and the simulated receiver device also acts as a transmitter.

11. A method as claimed in claim 9 or 10 comprising the simulated radio frequency transmitter device storing a data packet in the shared memory resource, and preferably further comprising the simulated radio frequency receiver device retrieving the data packet stored in the shared memory resource.

12. A method as claimed in any of claims 9 to 11, wherein: the simulated transmitter device is provided by a first integrated development environment; the simulated receiver device is provided by a second integrated development environment; and the shared memory resource is outside the integrated development environments.

13. A method as claimed in any of claims 9 to 12 comprising the shared memory resource notifying the simulated radio frequency receiver device that a packet has been stored there, and preferably further comprising the simulated radio frequency receiver device checking an RF channel and/or address of the packet, and/or preferably further comprising the simulated radio frequency receiver device triggering an interrupt if said RF channel and/or said address of the packet matches a predetermined value for the simulated radio frequency receiver device.

14. A method as claimed in any of claims 9 to 13 comprising the shared memory resource notifying the simulated radio frequency receiver device that a packet has been stored there.

15. A method as claimed in any of claims 9 to 14 comprising the shared memory resource inserting bit errors into the packets stored therein or deleting packets.
